(19) Europäisches Patentamt

European Patent Office

Office européen des brevets

(11) **EP 0 945 526 A1**

(12) **EUROPÄISCHE PATENTANMELDUNG**

(43) Veröffentlichungstag:
29.09.1999 Patentblatt 1999/39

(51) Int. Cl.$^6$: **C23C 28/00**, C23C 14/22,
C23C 14/35

(21) Anmeldenummer: 99102425.8

(22) Anmeldetag: 09.02.1999

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 05.03.1998 DE 19809409

(71) Anmelder: Leybold Systems GmbH
63450 Hanau (DE)

(72) Erfinder:
• Budke, Elisabeth Dr.
50354 Hürth (DE)
• Krempel-Hesse, Jörg Dr.
63683 Eckartsborn (DE)
• Maidhof, Hans
63773 Goldbach (DE)
• Schüssler, Hans
66578 Schiffweiler (DE)

(54) **Messingfarbige Beschichtung mit einer farbgebenden nitridischen Schicht**

(57) Bei einem Verfahren zur Herstellung einer messingfarbenen Schicht für Armaturen, Beschläge oder Artikel des täglichen Bedarfs erfolgt das Aufbringen einer Zwischenschicht auf das Substrat oder auf eine diese überziehende Grundschicht durch Aufstäuben, wozu dem Substrat benachbart in der Prozeßkammer eine Magnetronquelle mit einem Zirkonium-Target angeordnet ist und als Prozeßgas ein Gemisch aus Argon und Stickstoff dient und das Aufbringen der Deckschicht durch Aufstäuben unter Verwendung eines Zirkonium-Targets in einem Gemisch aus Argon und Sauerstoff als Prozeßgas, wobei die Deckschicht durch Beschuß mit niederenergetischen Ionen in einem Gemisch aus Argon als Trägergas und einem Reaktivgas, beispielsweise Sauerstoff oder Wasserstoff, modifiziert wird.

**Beschreibung**

Die Erfindung betrifft eine messingfarbige Beschichtung mit einer farbgebenden nitridischen Schicht für Badarmaturen, Beschläge und Artikel des täglichen Bedarfs. Die Erfindung betrifft ferner die mit dieser Beschichtung versehenen Artikel und das Verfahren zu ihrer Herstellung.

Bekannt ist eine goldfarbige, Zirkoniumnitrid enthaltende Beschichtung, wobei die Schicht aus Zirkoniumnitrid und Tantalnitrid mit einem Tantalanteil von 3 Gew.% bis 68 Gew.% zusammengesetzt ist (DE 37 28 836 C2).

Bekannt sind weiterhin Überzüge für metallische Gebrauchs- und Ziergegenstände (DE 25 28 255), die Karbide und/oder Nitride und/oder Karbonitride und/oder Boride der Elemente Titan, Zirkonium, Hafnium, Niob, Tantal, Wolfram, Lanthan, Cer und Gadolinium enthalten. Diese Stoffe können einzeln, in Form von Mischungen oder Mischkristallen verwendet werden. Zum Aufbringen der Überzüge sind die Abscheidung aus der Gasphase, die Sputtertechnik und des Plasmaspritzen angegeben. Überzüge allein aus Titannitrid, aus Titankarbid, aus 10 % Titankarbid und 90 % Titannitrid, aus LaB$_6$ sowie aus 15 % Titankarbid und 85 % Titannitrid sind als besondere Beispiele aufgeführt.

Weiterhin sind Artikel bekannt (US 5,552,233) mit einer sowohl dekorativ wirkenden als auch die Gegenstände schützenden mehrlagigen Beschichtung, wobei die Schichten selbst den Eindruck von Messing vermitteln. Das Schichtpaket besteht aus einer ersten Schicht aus halbglänzendem Nickel, einer zweiten Schicht aus hochglänzendem Nickel, einer dritten Schicht aus einer Zinn-Nickel-Legierung, einer vierten Schicht aus Zirkonium oder Titan oder Zirkoniumnitrid und einer Deckschicht aus einer Zirkonium- oder Titanverbindung.

Weiterhin ist bereits ein Schichtpaket für ein Interferenzfilter vorgeschlagen worden (EP 0 622 654), bei dem auf ein Substrat aus durchscheinendem Werkstoff eine erste Schicht aus teilweise lichtdurchlässigem, dielektrischem Werkstoff, eine zweite Schicht aus Nickel oder Chromnitrid, darauffolgend eine dritte, reflektierende Metallschicht aus Silber, Gold, Kupfer oder Platin, darauffolgend eine vierte Schicht aus Nickel oder Chrom und schließlich eine Deckschicht aus Zirkoniumnitrid, Titannitrid oder Hafniumnitrid aufgebracht ist.

Schließlich ist ein Verfahren zur Herstellung goldfarbener Überzüge auf Substraten durch Verdampfen von Metallen bei Unterdruck bekannt (DE 30 27 404), bei dem die Metalle Titan, Zirkonium oder Hafnium sind, die in einer Stickstoff enthaltenden Restgasatmosphäre unter gleichzeitiger Aktivierung des Restgases durch eine elektrische Gasentladung aufgebracht werden, wobei die Gasentladung eine Niedervoltbogenentladung zwischen einer Glühkathode und einer Anode ist und das Restgas eine kohlenstoffhaltige, gasförmige Verbindung enthält und die zu beschichtenden Substrate auf eine gegenüber dem Gehäuse negative Vorspannung gelegt sind.

Der vorliegenden Erfindung liegt die Aufgabe zugrunde, ein Schichtsystem zu schaffen, bei dem die Farbe der Schichten so einstellbar ist, daß sie messingfarbig erscheint, auch bei intensiver Nutzung farbstabil, kratzfest, abriebfest, hart und korrosionsfest bleibt und in einfachen Anlagen und ohne Unterbrechung herstellbar ist.

Diese Aufgabe wird erfindungsgemäß dadurch gelöst, daß die nitridische Schicht eine Zirkoniumnitridschicht ist und unmittelbar auf das Substrat oder auf eine das Substrat überziehende Grundschicht, beispielsweise eine Zirkoniumschicht als Zwischenschicht aufgebracht ist, wobei zum Zwecke des Korrosionsschutzes als Deckschicht eine transparente oxidische Hartstoffschicht, vorzugsweise eine Zirkoniumoxidschicht niedergeschlagen ist, die durch Beschuß mit niederenergetischen Ionen in einem Gemisch aus Argon als Trägergas und einem Reaktivgas, beispielsweise Sauerstoff oder Wasserstoff, modifiziert ist.

Vorzugsweise erfolgt das Aufbringen der Zwischenschicht durch Aufstäuben, wozu dem Substrat benachbart in der Prozeßkammer eine Magnetronquelle mit einem Zirkonium-Target angeordnet ist und als Prozeßgas ein Gemisch aus Argon und Stickstoff dient, wobei das Aufbringen der Deckschicht durch Aufstäuben unter Verwendung eines ZirkoniumTargets in einem Gemisch aus Argon und Sauerstoff als Prozeßgas erfolgt und die Deckschicht durch Beschuß mit niederenergetischen Ionen mit Argon und Sauerstoff oder Argon und Wasserstoff modifiziert ist.

Mit Vorteil erfolgt die Modifizierung der Deckschicht in einem Druckbereich von $1*10^{-3}$ bis $1*10^{-1}$ mbar, vorzugsweise $1*10^{-2}$ mbar, wobei der Anteil von Sauerstoff im Prozeßgas etwa 10 % beträgt und die Ätzspannung auf 300 V bis 20.000 V, vorzugsweise 900 V eingestellt ist.

Die Erfindung läßt die verschiedensten Ausführungsmöglichkeiten zu; eine davon ist nachstehend anhand einer Zeichnung näher beschrieben.

Die Anlage zum Beschichten von Substraten wie beispielsweise Badarmaturen oder Möbelbeschlägen besteht im wesentliche aus einer Vakuumkammer 3 mit einem Anschluß 4 für eine Turbopumpe (Vakuumpumpe), einer in den Anschluß 4 eingebauten Saugleistungsregelung 5, einem elektrisch isolierten Substrathalter 8 für die Substrate 7,7',..., einem HF-Generator 6 mit Anpaßnetzwerk 9, einer dem Substrathalter 8 gegenüberliegend angeordneten Magnetronquelle 10 mit Target 11, Kühleinrichtung 12 und Magnetjoch 13, einem Stutzen 14 für den Einlaß von Prozeßgas in die Vakuumkammer 3 und einem Generator 15 mit Anpaßnetzwerk 16 für die Stromversorgung der Magnetronquelle 10.

Für die Herstellung eines Schichtsystems Zr / ZrN / ZrO$_2$ wurden die aus der nachstehenden Tabelle ersichtlichen Prozeßschritte und Prozeßparameter verwendet:

| Teilprozeß | Dicke [nm] | Zeit | Gase [sccm] | Druck [μbar] | Leistung [W] | Ätzspan- nung [V] | BIAS [V] |
|---|---|---|---|---|---|---|---|
| Freisputtern | --- | 2′ | Ar, 63 | 8 | 444 | --- | --- |
| Ar-Ätzen | --- | 2′ | Ar, 72,8 | 12 | --- | 800 | --- |
| Freisputtern | --- | 1′ | Ar, 63 | 8 | 444 | --- | --- |
| Zr-Schicht | 70 | 10″ | Ar, 63 | 8,3 | 444 | --- | --- |
| N₂-Konditio- nieren | --- | 30″ | Ar, 44,8 N₂, 4,8 | 5,1 | 444 | --- | --- |
| ZrN-Schicht | 330 | 2′ | Ar, 44,8 N₂, 4,8 | 5,3 | 444 | --- | 160 |
| O₂-Konditio- nieren | --- | 30″ | Ar, 63 O₂, 8,9 | 9,5 | 444 | --- | --- |
| ZrO₂-Schicht | 9 | 10″ | Ar, 63 O₂, 8,9 | 9,7 | 444 | --- | 160 |
| O₂-Ätzen | | 2′ | Ar, 68 O₂, 6,1 | 12 | --- | 900 | --- |

Durch Variation der Oxid-Schichtdicke und der Konzentration des Stickstoff-Anteils im Prozeßgas läßt sich die Farbe des dekorativen Schichtsystems verändern, so daß eine Farbanpassung in bestimmten Grenzen möglich ist.

Die optischen Eigenschaften eines mit den aus der Tabelle ersichtlichen Prozeßparametern erzeugten Schichtsystems sind:

$$L^*>85; \ a^*<-2,5; \ b^*=25...29$$

(Heißwassertest: T = 80°C; t = 24 h; deionisiertes Wasser (L < 0,5 S/cm, nicht entgast); Proben isoliert gelagert) Schichtdicke: 0,3 ... 0,6 μm.

Die gemessene Farbbeständigkeit und Farbwerte des Systems sind:

$$\Delta E_{ab} <1,0 \qquad a^*=-2,5 \qquad b^*=29,0 \qquad L^*>85$$

Wie die vorstehende Tabelle zeigt, wurde das Schichtpaket nachträglich im oberflächennahen Bereich (< 20 nm) durch Beschuß mit niederenergetischen Ionen modifiziert, wobei ein Gemisch aus Edelgasionen in Kombination mit reaktiven Ionen verwendet wurde. Hierdurch wurde eine erhebliche Verbesserung der Langzeitstabilität dieser Funktionsschichten/-systeme, insbesondere eine Verbesserung der Korrosionsbeständigkeit der behandelten Schichten erzielt. Der beschriebene Prozeß zeichnet sich insbesondere durch seine Einfachheit aus, da zu seiner Durchführung der in den meisten Beschichtungsanlagen bereits vorhandene, zur Substratreinigung genutzte Plasmaätzprozeß verwendet werden kann.

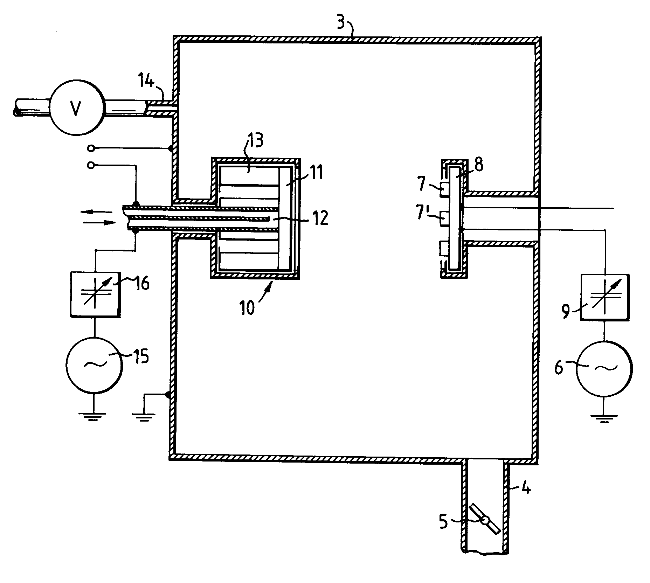

**Patentansprüche**

1. Messingfarbige Beschichtung mit einer farbgebenden nitridischen Schicht für Armaturen, Beschläge oder Artikel des täglichen Bedarfs, wobei die nitridische Schicht eine Zirkoniumnitridschicht ist und unmittelbar auf das Substrat oder auf eine das Substrat überziehende Grundschicht, beispielsweise eine Zirkoniumschicht als Zwischenschicht aufgebracht ist, wobei auf die Zwischenschicht als Deckschicht eine transparente oxidische Hartstoffschicht, vorzugsweise eine Zirkoniumoxidschicht niedergeschlagen ist, **dadurch gekennzeichnet,** daß die Deckschicht durch Beschuß mit niederenergetischen Ionen in einem Gemisch aus Argon als Trägergas und einem Reaktivgas, beispielsweise Sauerstoff oder Wasserstoff, modifiziert ist.

2. Verfahren zur Herstellung einer messingfarbenen Schicht für Armaturen, Beschläge oder Artikel des täglichen Bedarfs, **dadurch gekennzeichnet,** daß das Aufbringen einer Zwischenschicht auf das Substrat oder auf eine diese überziehende Grundschicht durch Aufstäuben erfolgt, wozu dem Substrat benachbart in der Prozeßkammer eine Magnetronquelle mit einem Zirkonium-Target angeordnet ist und als Prozeßgas ein Gemisch aus Argon und Stickstoff dient, wobei das Aufbringen der Deckschicht durch Aufstäuben unter Verwendung eines Zirkonium-Targets in einem Gemisch aus Argon und Sauerstoff als Prozeßgas erfolgt und die Deckschicht durch Beschuß mit niederenergetischen Ionen in einem Gemisch aus Argon als Tragergas und einem Reaktivgas, beispielsweise Sauerstoff oder Wasserstoff, modifiziert wird.

3. Verfahren nach Anspruch 2, **dadurch gekennzeichnet,** daß zur Modifizierung der Deckschicht die Behandlung in einem Druckbereich von $1*10^{-3}$ bis $1*10^{-1}$ mbar, vorzugsweise $1*10^{-2}$ mbar erfolgt, wobei der Anteil von Sauerstoff im Prozeßgas etwa 10 % und die Ätzspannung 300 V bis 20.000 V, vorzugsweise etwa 900 V beträgt.

Europäisches
Patentamt

**EUROPÄISCHER RECHERCHENBERICHT**

Nummer der Anmeldung

| | **EINSCHLÄGIGE DOKUMENTE** | | EP 99102425.8 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int Cl6) |
| A | DE 3731127 A1 (VAC-TEC SYSTEMS, INC.) 22. September 1988, ganzes Dokument. -- | 1-3 | C 23 C 28/00 C 23 C 14/22 C 23 C 14/35 |
| A | US 5122252 A (LATZ et al.) 16. Juni 1992, ganzes Dokument. ---- | 2 | |

RECHERCHIERTE SACHGEBIETE (Int. Cl6)

C 23 C

Der vorliegende Recherchenbericht wurde für alle Patentansprüche erstellt.

| Recherchenort | Abschlußdatum der Recherche | Prüfer |
|---|---|---|
| WIEN | 29-06-1999 | BECK |

ANHANG ZUM EUROPÄISCHEN RECHERCHENBERICHT
ÜBER DIE EUROPÄISCHE PATENTANMELDUNG NR. EP 99102425.8

In diesem Anhang sind die Mitglieder der Patentfamilien der im obengenannten europäischen Recherchenbericht angeführten Patentdokumente angegeben.
Die Angaben über die Familienmitglieder entsprechen dem Stand der EPIDOS-INPADOC-Datei am 1.7.1999
Diese Angaben dienen zur Unterrichtung und erfolgen ohne Gewähr.

| Im Recherchenbericht angeführtes Patentdokument | Datum der Veröffentlichung | Mitglied(er) der Patentfamilie | Datum der Veröffentlichung |
|---|---|---|---|
| DE A1 3731127 | 22-09-1988 | CH A 675258 | 14-09-1990 |
| | | DE C2 3731127 | 15-11-1990 |
| | | FR A1 2612204 | 16-09-1988 |
| | | GB A0 8719185 | 23-09-1987 |
| | | GB A1 2202237 | 21-09-1988 |
| | | JP A2 63223161 | 16-09-1988 |
| | | JP B4 4005750 | 03-02-1992 |
| | | NL A 8702404 | 03-10-1988 |
| US A 5122252 | 16-06-1992 | DE A1 3920835 | 03-01-1991 |
| | | DE C2 3920835 | 18-12-1997 |

Bezüglich näherer Einzelheiten zu diesem Anhang siehe Amtsblatt des Europäischen Patentamtes, Nr. 12/82.